# EUROPÄISCHE PATENTANMELDUNG

(11) **EP 4 112 587 A1**
(43) Veröffentlichungstag der Anmeldung: **04.01.2023**
(21) Anmeldenummer: 21182216.8
(22) Anmeldetag: 29.06.2021
(51) Int. Cl.: C04B 37/02, B23K 35/30, B23K 1/008, B23K 35/00, B23K 35/38, C04B 35/64, C04B 35/626

(54) **VERFAHREN ZUR HERSTELLUNG EINES METALL-KERAMIK-SUBSTRATS MITTELS SCHNELLEM HEIZEN**

(71) Anmelder: Heraeus Deutschland GmbH & Co. KG, 63450 Hanau (DE)
(72) Erfinder: Schwoebel, Andre, 64720 Michelstadt (DE); Miric, Anton-Zoran, 63755 Alzenau (DE); Wacker, Richard, 96135 Unteraurach (DE); Schnee, Daniel, 63505 Langenselbold (DE)
(74) Vertreter: Heraeus IP

(57) **Zusammenfassung**

Die Erfindung betrifft ein Verfahren zur Herstellung eines Metall-Keramik-Substrats. Mit dem Verfahren kann ein Metall-Keramik-Substrat mit einer erhöhten Wärme- und Stromleitfähigkeit erhalten werden. Das Verfahren umfasst die Schritte: a) Bereitstellen eines Stapels enthaltend a1) einen Keramikkörper, a2) eine Metallfolie und a3) ein Lötmaterial, das mit dem Keramikkörper und der Metallfolie in Kontakt steht, wobei das Lötmaterial umfasst: (i) ein Metall mit einem Schmelzpunkt von wenigstens 700°C, vorzugsweise Cu, (ii) ein Metall mit einem Schmelzpunkt von weniger als 700°C, vorzugsweise ausgewählt aus der Gruppe Sn, Bi, In, Ga, Zn, Sb oder Mg und (iii) ein Aktivmetall, vorzugsweise ausgewählt aus der Gruppe Hfm Ti, Zr, Nb, Ta, V und Ce, und b) Erhitzen des Stapels, wobei wenigstens eine der folgenden Bedingungen erfüllt ist: b1) die Hochtemperaturheizdauer beträgt nicht mehr als 60 min; b2) die Spitzentemperaturheizdauer beträgt nicht mehr als 30 min; b3) die Aufheizdauer liegt bei nicht mehr als 60 min.

## Beschreibung

Die vorliegende Erfindung betrifft ein Verfahren zur Herstellung eines Metall-Keramik-Substrats.

Metall-Keramik-Substrate spielen eine wichtige Rolle im Bereich der Leistungselektronik. Sie sind ein maßgebliches Element beim Aufbau von elektronischen Bauteilen und sorgen für eine schnelle Ableitung hoher Wärmemengen beim Betrieb dieser Bauteile. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund gebrannt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

Trotz offensichtlicher Vorteile weist das DCB-Verfahren zwei Hauptnachteile auf. Erstens muss das Verfahren bei relativ hohen Temperaturen durchgeführt werden, nämlich etwas unterhalb des Schmelzpunktes von Kupfer. Zweitens kann das Verfahren nur für Keramiken auf Oxidbasis wie Aluminiumoxid oder oberflächlich oxidiertes Aluminiumnitrid verwendet werden. Daher besteht ein Bedarf an einem alternativen Verfahren zur Herstellung von Metall-Keramik-Substraten unter weniger strengen Bedingungen. In einem alternativen Verfahren können Metallfolien bei Temperaturen von etwa 650 bis 1000°C mit Keramikkörpern verbunden werden, wobei ein spezielles Lot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Um Probleme im Zusammenhang mit der Migration von Silber zu vermeiden, kann es vorteilhaft sein, silberfreie Lote zur Verbindung von Metallfolien mit Keramikkörpern zu verwenden. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat. Die derart hergestellten Metall-Keramik-Substrate weisen daher neben einer Metallschicht und einer Keramikschicht eine zwischen der Metallschicht und der Keramikschicht liegende Verbindungsschicht auf, die ein Aktivmetall enthält.

Aufgrund der stetig steigenden Anforderungen im Bereich der Leistungselektronik wächst auch der Bedarf, die Wärme- und Stromleitfähigkeit von Metall-Keramik-Substraten, die unter Verwendung eines Lötmaterials hergestellt werden, das ein Metall mit einem Schmelzpunkt von wenigstens 700°C, ein Metall mit einem Schmelzpunkt von weniger als 700°C und ein Aktivmetall enthält, weiter zu verbessern.

Bisherige Ansätze zur Steigerung der Wärme- und Stromleitfähigkeit von Metall-Keramik-Substraten konzentrierten sich darauf, die Zusammensetzung der Verbindungsschicht zwischen der Metallschicht und der Keramikschicht zu variieren. Allerdings kann es aus mehreren Gründen vorteilhaft sein, dass die Zusammensetzung der Verbindungsschicht unverändert bleibt. So kann beispielsweise eine gegebene Zusammensetzung der Verbindungsschicht in idealer Weise andere technische Anforderungen als die Wärme- und Stromleitfähigkeit erfüllen, leicht herstellbar oder auch kostengünstiger sein. Vorteilhaft wäre es daher, die Wärme- und Stromleitfähigkeit von Metall-Keramik-Substraten bei einer gegebenen Zusammensetzung der Verbindungsschicht durch geeignete Verfahrensmaßnahmen zu verbessern.

Die Aufgabe der vorliegenden Erfindung besteht daher darin, ein Verfahren bereitzustellen, mit dem unter Verwendung eines Lötmaterials, das ein Metall mit einem Schmelzpunkt von wenigstens 700°C, ein Metall mit einem Schmelzpunkt von weniger als 700°C und ein Aktivmetall enthält, ein Metall-Keramik-Substrat mit einer erhöhten Wärme- und Stromleitfähigkeit erhalten werden kann.

Diese Aufgabe wird gelöst durch das Verfahren von Anspruch 1. Die Erfindung stellt daher ein Verfahren zur Herstellung eines Metall-Keramik-Substrats bereit, das die folgenden Schritte umfasst:
a) Bereitstellen eines Stapels enthaltend
   a1) einen Keramikkörper,
   a2) eine Metallfolie und
   a3) ein Lötmaterial, das mit dem Keramikkörper und der Metallfolie in Kontakt steht, wobei das Lötmaterial umfasst:
      (i) ein Metall mit einem Schmelzpunkt von wenigstens 700°C,
      (ii) ein Metall mit einem Schmelzpunkt von weniger als 700°C und
      (iii) ein Aktivmetall, und
b) Erhitzen des Stapels, wobei wenigstens eine der folgenden Bedingungen erfüllt ist:
   b1) die Hochtemperaturheizdauer beträgt nicht mehr als 60 min, wobei sich die Hochtemperaturheizdauer auf die Zeitdauer bezieht, bei der der Stapel beim Erhitzen einer Temperatur ausgesetzt ist, die wenigstens der Spitzentemperatur - 250°C entspricht;
   b2) die Spitzentemperaturheizdauer beträgt nicht mehr als 30 min, wobei sich die Spitzentemperaturheizdauer auf die Zeitdauer bezieht, bei der der Stapel beim Erhitzen einer Temperatur ausgesetzt ist, die wenigstens der Spitzentemperatur - 50°C entspricht;
   b3) die Aufheizdauer liegt bei nicht mehr als 60 min, wobei die Aufheizdauer den Zeitraum bezeichnet, den der Stapel benötigt, um ausgehend von einer Temperatur von 100°C die Spitzentemperatur zu erreichen.

Beim erfindungsgemäßen Verfahren wird zunächst ein Stapel bereitgestellt, der einen Keramikkörper, eine Metallfolie und ein Lötmaterial, das mit dem Keramikkörper und der Metallfolie in Kontakt steht, enthält.

In dem Stapel befindet sich das Lötmaterial daher vorzugsweise zwischen dem Keramikkörper und der Metallfolie. Gemäß einer bevorzugten Ausführungsform enthält der Stapel einen Keramikkörper, eine (erste) Metallfolie, ein (erstes) Lötmaterial, das mit dem Keramikkörper und der ersten Metallfolie in Kontakt steht, eine zweite Metallfolie und ein zweites Lötmaterial, das mit dem Keramikkörper und der zweiten Metallfolie in Kontakt steht. Gemäß dieser Ausführungsform befindet sich vorzugsweise zwischen dem Keramikkörper und der (ersten) Metallfolie ein (erstes) Lötmaterial und zwischen dem Keramikkörper und der zweiten Metallfolie ein zweites Lötmaterial. Ferner entspricht gemäß dieser Ausführungsform das erste Lötmaterial vorzugsweise dem zweiten Lötmaterial.

Der Keramikkörper weist daher vorzugsweise eine erste Oberfläche und eine zweite Oberfläche auf. Die Metallfolie weist vorzugsweise eine erste Oberfläche auf. Die zweite Metallfolie weist - soweit vorhanden - vorzugsweise eine erste Oberfläche auf. Gemäß einer bevorzugten Ausführungsform befindet sich daher im Stapel das (erste) Lötmaterial zwischen der ersten Oberfläche des Keramikkörpers und der ersten Oberfläche der (ersten) Metallfolie. Gemäß einer weiteren bevorzugten Ausführungsform enthält der Stapel ein zweites Lötmaterial, das mit der zweiten Oberfläche des Keramikkörpers und der ersten Oberfläche der zweiten Metallfolie in Kontakt steht. Gemäß dieser Ausführungsform befindet sich vorzugsweise im Stapel das (erste) Lötmaterial zwischen der ersten Oberfläche des Keramikkörpers und der ersten Oberfläche der (ersten) Metallfolie und das zweite Lötmaterial zwischen der zweiten Oberfläche des Keramikkörpers und der ersten Oberfläche der zweiten Metallfolie. Gemäß einer weiteren bevorzugten Ausführungsform befindet sich zwischen dem Keramikkörper und der (ersten) Metallfolie neben dem erfindungsgemäßen Lötmaterial keine weitere Schicht. Gemäß noch einer weiteren Ausführungsform befindet sich zwischen dem Keramikkörper und der - soweit vorhanden - zweiten Metallfolie neben dem erfindungsgemäßen Lötmaterial keine weitere Schicht.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siluziumnitridkeramiken und Aluminiumoxidkeramiken (wie zum Beispiel ZTA ("Zirconia Toughened Alumina") -Keramiken) besteht. Der Keramikkörper weist vorzugsweise eine Dicke von 0,05 - 10 mm, mehr bevorzugt im Bereich von 0,1 - 5 mm und besonders bevorzugt im Bereich von 0,15 - 3 mm auf.

Das Metall der Metallfolie ist vorzugsweise aus der Gruppe ausgewählt, die aus Kupfer, Aluminium und Molybdän besteht. Gemäß einer besonders bevorzugten Ausführungsform ist das Metall der Metallfolie aus der Gruppe ausgewählt, die aus Kupfer und Molybdän besteht. Gemäß einer ganz besonders bevorzugten Ausführungsform ist das Metall der Metallfolie Kupfer. Die Metallfolie weist vorzugsweise eine Dicke im Bereich von 0,01 - 10 mm, mehr bevorzugt im Bereich von 0,03 - 5 mm und besonders bevorzugt im Bereich von 0,05 - 3 mm auf.

Das Lötmaterial umfasst (i) ein Metall mit einem Schmelzpunkt von wenigstens 700°C, (ii) ein Metall mit einem Schmelzpunkt von weniger als 700°C und (iii) ein Aktivmetall.

Gemäß einer bevorzugten Ausführungsform liegen (i) das Metall mit einem Schmelzpunkt von wenigstens 700°C, (ii) das Metall mit einem Schmelzpunkt von weniger als 700°C und (iii) das Aktivmetall als Bestandteil wenigstens einer Metallkomponente vor. Daher umfasst das Lötmaterial vorzugsweise wenigstens eine Metallkomponente, die (i) das Metall mit einem Schmelzpunkt von wenigstens 700°C, (ii) das Metall mit einem Schmelzpunkt von weniger als 700°C und (iii) das Aktivmetall aufweist. So kann es beispielsweise bevorzugt sein, dass das Lötmaterial umfasst: eine Metallkomponente (i), die ein Metall mit einem Schmelzpunkt von wenigstens 700°C enthält, eine Metallkomponente (ii), die ein Metall mit einem Schmelzpunkt von weniger als 700°C enthält, und eine Metallkomponente (iii) die ein Aktivmetall enthält. Ferner kann es auch bevorzugt sein, dass das Lötmaterial umfasst: eine Metallkomponente (i), die ein Mitglied aus der Gruppe enthält, die aus (i) einem Metall mit einem Schmelzpunkt von wenigstens 700°C, (ii) einem Metall mit einem Schmelzpunkt von weniger als 700°C und (iii) einem Aktivmetall besteht, und eine Metallkomponente (ii), die Mitglieder aus der Gruppe, die aus (i) einem Metall mit einem Schmelzpunkt von wenigstens 700°C, (ii) einem Metall mit einem Schmelzpunkt von weniger als 700°C und (iii) einem Aktivmetall besteht, enthält, die nicht in Metallkomponente (i) enthalten sind. Der Begriff der Metallkomponente ist nicht weiter eingeschränkt. Er umfasst neben Metallen und Metalllegierungen auch Metallverbindungen wie intermetallische Phasen und andere Verbindungen wie beispielsweise Metallhydride. Gemäß einer bevorzugten Ausführungsform ist die Metallkomponente daher aus der Gruppe ausgewählt, die aus Metallen, Metalllegierungen und Metallverbindungen besteht.

Das Lötmaterial umfasst (i) ein Metall mit einem Schmelzpunkt von wenigstens 700°C. Das Metall mit einem Schmelzpunkt von wenigstens 700°C weist vorzugsweise einen Schmelzpunkt von wenigstens 850°C und besonders bevorzugt einen Schmelzpunkt von wenigstens 1000°C auf. Gemäß einer bevorzugten Ausführungsform ist das Metall mit einem Schmelzpunkt von wenigstens 700°C aus der Gruppe ausgewählt, die aus Kupfer, Nickel, Wolfram und Molybdän besteht. Gemäß einer besonders bevorzugten Ausführungsform ist das Metall mit einem Schmelzpunkt von wenigstens 700°C Kupfer. Gemäß einer weiteren bevorzugten Ausführungsform umfasst das Lötmaterial eine Metallkomponente (i), die ein Metall mit einem Schmelzpunkt von wenigstens 700°C enthält. Gemäß einer besonders bevorzugten Ausführungsform umfasst das Lötmaterial eine Metallkomponente (i), die Kupfer enthält. Gemäß einer weiteren bevorzugten Ausführungsform handelt es sich bei Metallkomponente (i) um Kupfer.

Das Lötmaterial umfasst (ii) ein Metall mit einem Schmelzpunkt von weniger als 700°C. Das Metall mit einem Schmelzpunkt von weniger als 700°C weist vorzugsweise einen Schmelzpunkt von weniger als 600°C und besonders bevorzugt einen Schmelzpunkt von weniger als 550°C auf. Gemäß einer bevorzugten Ausführungsform ist das Metall mit einem Schmelzpunkt von weniger als 700°C aus der Gruppe ausgewählt, die aus Zinn, Bismut, Indium, Gallium, Zink, Antimon und Magnesium besteht. Gemäß einer besonders bevorzugten Ausführungsform ist das Metall mit einem Schmelzpunkt von weniger als 700°C Zinn. Gemäß einer weiteren bevorzugten Ausführungsform umfasst das Lötmaterial eine Metallkomponente (ii), die ein Metall mit einem Schmelzpunkt von weniger als 700°C enthält. Gemäß einer besonders bevorzugten Ausführungsform ist die Metallkomponente (ii) eine Legierung eines Metalls mit einem Schmelzpunkt von weniger als 700°C mit einem weiteren Metall. Das weitere Metall kann zum Beispiel aus der Gruppe ausgewählt sein, die aus Metallen mit einem Schmelzpunkt von weniger als 700°C, Metallen mit einem Schmelzpunkt von wenigstens 700°C und Aktivmetallen besteht. Gemäß einer weiteren bevorzugten Ausführungsform ist die Metallkomponente (ii) enthaltend ein Metall mit einem Schmelzpunkt von weniger als 700°C aus der Gruppe ausgewählt, die aus Zinn, Bismut, Indium, Gallium, Zink, Antimon, Magnesium, Zinn-Kupfer-Legierungen, Zinn-Bismut-Legierungen, Zinn-Antimon-Legierungen, Zinn-Zink-Bismut-Legierungen und Indium-Zinn-Legierungen besteht. Gemäß noch einer weiteren besonders bevorzugten Ausführungsform ist die Metallkomponente (ii) enthaltend ein Metall mit einem Schmelzpunkt von weniger als 700°C aus der Gruppe ausgewählt, die aus Zinn, Zinn-Kupfer-Legierungen, Zinn-Bismut-Legierungen, Zinn-Antimon-Legierungen, Zinn-Zink-Bismut-Legierungen und Indium-Zinn-Legierungen besteht.

Das Lötmaterial umfasst ein Aktivmetall. Das Aktivmetall ist vorzugsweise ein Metall, das durch chemische Reaktion eine Verbindung zwischen dem aus Bestandteilen des Lötmaterials gebildeten Lot und der Keramik herstellt. Gemäß einer bevorzugten Ausführungsform ist das Aktivmetall aus der Gruppe ausgewählt, die aus Hafnium, Titan, Zirkonium, Niob, Tantal, Vanadium und Cer besteht. Gemäß einer mehr bevorzugten Ausführungsform ist das Aktivmetall aus der Gruppe ausgewählt, die aus Hafnium, Titan, Zirkonium, Niob und Cer besteht. Gemäß einer besonders bevorzugten Ausführungsform ist das Aktivmetall aus der Gruppe ausgewählt, die aus Hafnium, Titan und Zirkonium besteht. Gemäß einer ganz besonders bevorzugten Ausführungsform ist das Aktivmetall Titan. Gemäß einer weiteren bevorzugten Ausführungsform umfasst das Lötmaterial eine Metallkomponente (iii), die ein Aktivmetall enthält. Gemäß einer besonders bevorzugten Ausführungsform ist die Metallkomponente (iii) eine Aktivmetalllegierung oder eine Aktivmetallverbindung, besonders bevorzugt ein Aktivmetallhydrid. Die Metallkomponente (iii) ist vorzugsweise aus der Gruppe ausgewählt, die aus Titanhydrid, Titan-Zirkonium-Kupfer-Legierungen, Zirkoniumhydrid und Hafniumhydrid besteht. Gemäß einer besonders bevorzugten Ausführungsform ist die Metallkomponente (iii) aus der Gruppe ausgewählt, die aus Hafniumhydrid, Titanhydrid und Zirkoniumhydrid besteht. Gemäß einer ganz besonders bevorzugten Ausführungsform ist die Metallkomponente (iii) Titanhydrid.

Gemäß einer bevorzugten Ausführungsform beträgt der Anteil des Metalls mit einem Schmelzpunkt von wenigstens 700°C 50 - 90 Gewichtsprozent, mehr bevorzugt 55 - 90 Gewichtsprozent, besonders bevorzugt 65 - 90 Gewichtsprozent und ganz besonders bevorzugt 70 - 90 Gewichtsprozent, bezogen auf das Gesamtmetallgewicht des Lötmaterials. Gemäß einer weiteren bevorzugten Ausführungsform beträgt der Anteil des Metalls mit einem Schmelzpunkt von weniger als 700°C 5 - 45 Gewichtsprozent, mehr bevorzugt 5 - 40 Gewichtsprozent, besonders bevorzugt 5 - 30 Gewichtsprozent und ganz besonders bevorzugt 5 - 25 Gewichtsprozent, bezogen auf das Gesamtmetallgewicht des Lötmaterials. Gemäß noch einer weiteren bevorzugten Ausführungsform beträgt der Anteil des Aktivmetalls 1 - 20 Gewichtsprozent, mehr bevorzugt 1 - 15 Gewichtsprozent, besonders bevorzugt 1 - 12 Gewichtsprozent und ganz besonders bevorzugt 1 - 10 Gewichtsprozent, bezogen auf das Gesamtmetallgewicht des Lötmaterials.

Das Lötmaterial ist vorzugsweise silberfrei oder silberarm. Daher beträgt der Anteil von Silber vorzugsweise weniger als 3,0 Gewichtsprozent, besonders bevorzugt weniger als 1,0 Gewichtsprozent und ganz besonders bevorzugt weniger als 0,2 Gewichtsprozent, bezogen auf das Gesamtmetallgewicht des Lötmaterials. Durch die Abwesenheit von Silber oder die Gegenwart von nur geringen Silbermengen kann eine Migration von Silber an den Rändern der Verbindungsschicht im fertigen Metall-Keramik-Substrat vermieden oder reduziert werden. Überraschenderweise wurde gefunden, dass mit dem erfindungsgemäßen Verfahren auch die Strom- und Wärmeleitfähigkeit von Metall-Keramik-Substraten mit derart reduziertem Silberanteil verbessert werden kann. Dies ist insofern überraschend, als dass derartige Metall-Keramik-Substrate aufgrund des Ersetzens von Silber als Lotbasis praktisch eine eigenständige Verbindungsklasse darstellen, die andere Materialeigenschaften aufweist, was zum Teil eine Anpassung im Hinblick auf die übrigen Lotbestandteile und modifizierte Fügebedingungen erforderlich macht.

Gemäß einer weiteren bevorzugten Ausführungsform ist das Lötmaterial siliziumarm oder siliziumfrei. Daher beträgt der Anteil von Silizium vorzugsweise weniger als 3,0 Gewichtsprozent, besonders bevorzugt weniger als 1,0 Gewichtsprozent und ganz besonders bevorzugt weniger als 0,5 Gewichtsprozent, bezogen auf das Gesamtgewicht aller Metalle und Halbmetalle im Lötmaterial.

Das Lötmaterial steht mit dem Keramikkörper und der Metallfolie in Kontakt. Dementsprechend befindet sich das Lötmaterial vorzugsweise zwischen dem Keramikkörper und der Metallfolie. Zum Beispiel kann das Lötmaterial auf dem Keramikkörper bereitgestellt und anschließend die Metallfolie auf das Lötmaterial aufgebracht werden. Das Lötmaterial ist vorzugsweise wenigstens ein Material, das aus der Gruppe ausgewählt ist, die aus Pasten, Folien und Abscheidungen besteht, die ein Metall mit einem Schmelzpunkt von wenigstens 700°C, ein Metall mit einem Schmelzpunkt von weniger als 700°C und ein Aktivmetall aufweisen. Das Lötmaterial kann daher auch aus zwei oder mehreren Materialien unterschiedlicher Zusammensetzung gebildet sein. Beispielsweise kann ein, vorzugsweise direkt mit dem Keramikkörper in Kontakt stehendes, erstes Material eine Metallkomponente (iii) enthaltend ein Aktivmetall aufweisen, und ein vorzugsweise zwischen dem ersten Material und der Metallfolie angeordnetes zweites Material Metallkomponente (i) enthaltend ein Metall mit einem Schmelzpunkt von wenigstens 700°C und Metallkomponente (ii) enthaltend ein Metall mit einem Schmelzpunkt von weniger als 700°C aufweisen.

Bei dem Lötmaterial kann es sich um eine Paste handeln. Die Paste enthält vorzugsweise (a) wenigstens eine Metallkomponente, die ein Metall mit einem Schmelzpunkt von wenigstens 700°C, ein Metall mit einem Schmelzpunkt von weniger als 700°C und ein Aktivmetall aufweist und (b) ein organisches Medium.

Das organische Medium ist vorzugsweise ein organisches Medium, das üblicherweise auf dem betreffenden technischen Gebiet verwendet wird. Vorzugsweise enthält das organische Medium ein organisches Bindemittel, ein organisches Dispersionsmittel oder eine Mischung davon.

Das organische Bindemittel wird vorzugsweise beim Erhitzen aus dem Lötmaterial entfernt. Vorzugsweise handelt es sich beim organischen Bindemittel um Thermoplasten oder Duroplasten. Beispiele für organische Bindemittel umfassen Zellulosederivate (wie Ethylzellulose, Butylzellulose und Zelluloseacetate), Polyether (wie Polyoxymethylen) und Acrylharze (wie Polymethylmethacrylate und Polybutylenmethacrylate).

Das organische Dispersionsmittel ist vorzugsweise eine organische Verbindung, die der Paste eine geeignete Viskosität verleiht und die beim Trocknen der Paste oder beim Erhitzen ausgetrieben wird. Das organische Dispersionsmittel kann zum Beispiel aus aliphatischen Alkoholen, Terpenalkoholen, alizyklischen Alkoholen, aromatischen zyklischen Carbonsäureestern, aliphtischen Estern, Karbitolen und aliphatischen Polyolen ausgewählt sein. Beispiele für das organische Dispersionsmittel umfassen Oktanol, Dekanol, Terpineole (zum Beispiel Dihydroterpineol), Cyclohexanol, Dibutylphthalat, Karbitol, Ethylkarbitol, Ethylenglykol, Butandiol und Glycerin.

Die Paste kann darüber hinaus fachübliche Zusatzstoffe enthalten. Beispiele für solche Zusatzstoffe umfassen anorganische Bindemittel (wie Glasfritten), Stabilisatoren, Tenside, Dispergiermittel, Rheologiemodifizierungsmittel, Benetzungshilfen, Entschäumer, Füllstoffe und Härter.

Gemäß einer bevorzugten Ausführungsform beträgt der Anteil an der wenigstens einen Metallkomponente, die ein Metall mit einem Schmelzpunkt von wenigstens 700°C, ein Metall mit einem Schmelzpunkt von weniger als 700°C und ein Aktivmetall aufweist 20 - 95 Gewichtsprozent, mehr bevorzugt 30 - 95 Gewichtsprozent und besonders bevorzugt 75 - 95 Gewichtsprozent, bezogen auf das Gesamtgewicht der Paste. Gemäß einer weiteren bevorzugten Ausführungsform beträgt der Anteil an dem organischen Medium 5 - 80 Gewichtsprozent, mehr bevorzugt 5 - 70 Gewichtsprozent und besonders bevorzugt 5 - 25 Gewichtsprozent, bezogen auf das Gesamtgewicht der Paste.

Gemäß einer weiteren bevorzugten Ausführungsform ist das Verhältnis des Gesamtgewichts der (a) wenigstens einen Metallkomponente, die ein Metall mit einem Schmelzpunkt von wenigstens 700°C, ein Metall mit einem Schmelzpunkt von weniger als 700°C und ein Aktivmetall aufweist, zum Gewicht des (b) organischen Mediums wenigstens 5 : 1, besonders bevorzugt wenigstens 7 : 1 und ganz besonders bevorzugt wenigstens 8 : 1. Gemäß einer weiteren bevorzugten Ausführungsform liegt das Verhältnis des Gesamtgewichts der (a) wenigstens einen Metallkomponente, die ein Metall mit einem Schmelzpunkt von wenigstens 700°C, ein Metall mit einem Schmelzpunkt von weniger als 700°C und ein Aktivmetall aufweist, zum Gewicht des (b) organischen Mediums im Bereich von 1 : 1 bis 20 : 1, besonders bevorzugt im Bereich von 2 : 1 bis 20 : 1 und ganz besonders bevorzugt im Bereich von 5 : 1 bis 15 : 1.

Zur Bereitstellung des Stapels wird die Paste vorzugsweise auf die Oberfläche des Keramikkörpers aufgetragen. Die Paste kann zum Beispiel durch ein Dispergierverfahren oder ein Druckverfahren aufgetragen werden. Geeignete Druckverfahren sind zum Beispiel Siebdruckverfahren, Inkjetdruckverfahren und Offsetdruckverfahren. Vorzugsweise wird die Paste auf die Oberfläche des Keramikkörpers durch ein Siebdruckverfahren aufgetragen.

Nach dem Pastenauftrag kann die Paste bei Bedarf vorgetrocknet werden. Die Vortrocknung kann bei Raumtemperatur oder bei erhöhter Temperatur erfolgen. Die Bedingungen für die Vortrocknung können in Abhängigkeit von dem in der Paste enthaltenen organischen Medium variieren. Die Vortrocknungstemperatur kann zum Beispiel im Bereich von 50 - 180°C liegen und liegt vorzugsweise im Bereich von 80 - 150°C. Die Vortrocknung erfolgt üblicherweise für einen Zeitraum von 2 min - 2 h und vorzugsweise für einen Zeitraum von 5 min - 1 h.

Im Anschluss kann die Metallfolie mit ihrer Oberfläche auf die - bei Bedarf vorgetrocknete - Paste aufgebracht werden, um einen Stapel zu erhalten.

Bei dem Lötmaterial kann es sich auch um eine Folie handeln.

Die Folie umfasst (i) ein Metall mit einem Schmelzpunkt von wenigstens 700°C, (ii) ein Metall mit einem Schmelzpunkt von weniger als 700°C und (iii) ein Aktivmetall. Zusätzlich kann die Folie weitere Bestandteile umfassen, wie zum Beispiel ein geeignetes Bindemittel.

Die Folie kann zum Beispiel erhalten werden, indem wenigstens eine Metallkomponente, die ein Metall mit einem Schmelzpunkt von wenigstens 700°C, ein Metall mit einem Schmelzpunkt von weniger als 700°C und ein Aktivmetall aufweist, sowie gegebenenfalls weitere Bestandteile homogenisiert und auf eine Temperatur erhitzt werden, die unterhalb der Schmelztemperatur des Metalls mit einem Schmelzpunkt von wenigstens 700°C, des Metalls mit einem Schmelzpunkt von weniger als 700°C und des Aktivmetalls liegt, die aber ausreichend ist, um eine Bindung zwischen den Metallen auszubilden. Diese Temperatur kann zum Beispiel wenigstens 200°C betragen.

Alternativ kann die Folie zum Beispiel erhalten werden, indem wenigstens eine Metallkomponente, die ein Metall mit einem Schmelzpunkt von wenigstens 700°C, ein Metall mit einem Schmelzpunkt von weniger als 700°C und ein Aktivmetall aufweist, sowie ein Bindemittel vermischt werden und die Mischung zu einem Grünkörper geformt und erhitzt wird. Beim Erhitzen kann das Bindemittel aushärten und eine Matrix formen, in der die Metalle verteilt sind.

Zur Bereitstellung des Stapels kann die Folie zum Beispiel auf die Keramik gelegt werden. Im Anschluss kann die Metallfolie mit ihrer Oberfläche auf die sich auf der Keramik befindliche Folie aufgebracht werden, um einen Stapel zu erhalten.

Gemäß einer weiteren Ausführungsform kann es sich bei dem Lötmaterial um eine Abscheidung handeln. Die Abscheidung des Lötmaterials kann zum Beispiel durch galvanische Abscheidung oder Gasphasenabscheidung erzeugt sein. Vorzugsweise wird die Abscheidung des Lötmaterials auf dem Keramikkörper erzeugt. Danach kann die Metallfolie auf das auf der Keramik abgeschiedene Lötmaterial aufgebracht werden, um einen Stapel zu erhalten.

Das Erhitzen des Stapels erfolgt vorzugsweise unter Erhalt eines Metall-Keramik-Substrats. Gemäß einer bevorzugten Ausführungsform erfolgt das Erhitzen, wobei unter Ausbildung einer stoffschlüssigen Verbindung zwischen dem Keramikkörper und der Metallfolie über das Lötmaterial ein Metall-Keramik-Substrat erhalten wird. Die Ausbildung der stoffschlüssigen Verbindung erfolgt vorzugsweise, indem das Aktivmetall eine Verbindung mit dem Keramikkörper eingeht und das Metall mit einem Schmelzpunkt von wenigstens 700°C, das Metall mit einem Schmelzpunkt von weniger als 700°C und das Metall der Metallfolie sich zu einer Legierung verbinden. Beim anschließenden Erstarren bildet sich dann eine stoffschlüssige Verbindung zwischen dem Keramikkörper und der Metallfolie über das Lötmaterial aus.

Das Erhitzen des Stapels erfolgt vorzugsweise so, dass eine stoffschlüssige Verbindung zwischen dem Keramikkörper und der Metallfolie über das Lötmaterial erzeugt wird.

Beim Erhitzen des Stapels sind wenigstens eine, besonders bevorzugt wenigstens zwei (also die Bedingungen b1 und b2 oder die Bedingungen b1 und b3 oder die Bedingungen b2 und b3), und ganz besonders bevorzugt alle der folgenden Bedingungen erfüllt:
b1) die Hochtemperaturheizdauer beträgt nicht mehr als 60 min, wobei sich die Hochtemperaturheizdauer auf die Zeitdauer bezieht, bei der der Stapel beim Erhitzen einer Temperatur ausgesetzt ist, die wenigstens der Spitzentemperatur - 250°C entspricht;
b2) die Spitzentemperaturheizdauer beträgt nicht mehr als 30 min, wobei sich die Spitzentemperaturheizdauer auf die Zeitdauer bezieht, bei der der Stapel beim Erhitzen einer Temperatur ausgesetzt ist, die wenigstens der Spitzentemperatur - 50°C entspricht;
b3) die Aufheizdauer liegt bei nicht mehr als 60 min, wobei die Aufheizdauer den Zeitraum bezeichnet, den der Stapel benötigt, um ausgehend von einer Temperatur von 100°C die Spitzentemperatur zu erreichen.

Beim Erhitzen wird der Stapel auf eine Spitzentemperatur erhitzt. Die Spitzentemperatur ist nicht weiter eingeschränkt und ist vorzugsweise kleiner gleich dem Schmelzpunkt des Metalls mit einem Schmelzpunkt von wenigstens 700°C und niedriger als der Schmelzpunkt des Metalls der Metallfolie. Gemäß einer bevorzugten Ausführungsform liegt die Spitzentemperatur wenigstens 10°C und besonders bevorzugt wenigstens 50°C unter dem Schmelzpunkt des Metalls der Metallfolie. Gemäß einer weiteren bevorzugten Ausführungsform beträgt die Spitzentemperatur wenigstens 700°C. Die Spitzentemperatur liegt bevorzugt im Bereich von 700 - 1100°C, besonders bevorzugt im Bereich von 750 - 1050°C und ganz besonders bevorzugt im Bereich von 800 - 1000°C. Hierin verwendet bezieht sich die Spitzentemperatur auf die am Stapel mittels eines Thermoelements gemessene Temperatur. Die Spitzentemperatur ist dabei die maximale am Stapel gemessene Temperatur. Um nachteilige Effekte wie eine übermäßige Kontraktion oder ein Herausquellen des geschmolzenen Metalls aufgrund einer zu hohen Fluidität des geschmolzenen Metalls zu verhindern, wird der Fachmann bestrebt sein, übermäßig hohe Spitzentemperaturen zu vermeiden.

Beim Erhitzen erfährt der Stapel eine Temperaturzufuhr für eine Heizdauer. Die Heizdauer bezieht sich hierin vorzugsweise auf die Zeitdauer, bei der der Stapel beim Erhitzen einer Temperatur von wenigstens 200°C ausgesetzt ist. Die Heizdauer ist nicht weiter eingeschränkt, solange sie ausreichend ist, um ein Benetzen der zu verbindenden Oberflächen und deren stoffschlüssige Verfügung zu gewährleisten. Gemäß einer bevorzugten Ausführungsform beträgt die Heizdauer wenigstens 5 min und besonders bevorzugt wenigstens 10 min. Gemäß einer weiteren bevorzugten Ausführungsform beträgt die Heizdauer nicht mehr als 5 h, besonders bevorzugt nicht mehr als 2 h und ganz besonders bevorzugt nicht mehr als 90 min. Die Heizdauer liegt vorzugsweise im Bereich von 5 min - 5 h, besonders bevorzugt im Bereich von 5 min - 2 h und ganz besonders bevorzugt im Bereich von 10 - 90 min.

Beim Erhitzen erfährt der Stapel eine Temperaturzufuhr für eine Hochtemperaturheizdauer. Die Hochtemperaturheizdauer bezieht sich hierin vorzugsweise auf die Zeitdauer, bei der der Stapel beim Erhitzen einer Temperatur ausgesetzt ist, die wenigstens der Spitzentemperatur - 250°C entspricht. Bei einer beispielhaften Spitzentemperatur von 900°C entspricht die Hochtemperaturheizdauer daher der Zeitdauer, bei der der Stapel beim Erhitzen wenigstens einer Temperatur von 650°C ausgesetzt ist. Gemäß einer bevorzugten Ausführungsform (Bedingung b1) beträgt die Hochtemperaturheizdauer nicht mehr als 60 min, mehr bevorzugt nicht mehr als 50 min, besonders bevorzugt nicht mehr als 45 min und ganz besonders bevorzugt nicht mehr als 40 min. Die Hochtemperaturheizdauer liegt vorzugsweise im Bereich von 2 - 60 min, mehr bevorzugt im Bereich von 3 - 50 min, besonders bevorzugt im Bereich von 5 - 45 min und ganz besonders bevorzugt im Bereich von 10 - 40 min.

Beim Erhitzen erfährt der Stapel eine Temperaturzufuhr für eine Spitzentemperaturheizdauer. Die Spitzentemperaturheizdauer bezieht sich hierin vorzugsweise auf die Zeitdauer, bei der der Stapel beim Erhitzen einer Temperatur ausgesetzt ist, die wenigstens der Spitzentemperatur - 50°C entspricht. Bei einer beispielhaften Spitzentemperatur von 900°C entspricht die Spitzentemperaturheizdauer daher der Zeitdauer, bei der der Stapel beim Erhitzen wenigstens einer Temperatur von 850°C ausgesetzt ist. Gemäß einer bevorzugten Ausführungsform (Bedingung b2) beträgt die Spitzentemperaturheizdauer nicht mehr als 30 min, mehr bevorzugt nicht mehr als 25 min, besonders bevorzugt nicht mehr als 20 min und ganz besonders bevorzugt nicht mehr als 15 min. Die Spitzentemperaturheizdauer liegt vorzugsweise im Bereich von 1 - 30 min, mehr bevorzugt im Bereich von 1 - 25 min, besonders bevorzugt im Bereich von 2 - 20 min und ganz besonders bevorzugt im Bereich von 3 - 15 min.

Gemäß einer weiteren besonders bevorzugten Ausführungsform liegt die Hochtemperaturheizdauer im Bereich von 10 - 40 min und die Spitzentemperaturheizdauer im Bereich von 3 - 15 min.

Gemäß einer weiteren bevorzugten Ausführungsform liegt das Verhältnis von Spitzentemperaturheizdauer (in min) zu Heizdauer (in min) bei nicht mehr als 1 : 2. Das Verhältnis von Spitzentemperaturheizdauer (in min) zu Heizdauer (in min) liegt vorzugsweise im Bereich von 1 : 2 bis 1 : 15, mehr bevorzugt im Bereich von 1 : 2 bis 1 : 10, besonders bevorzugt im Bereich von 1 : 2 bis 1 : 7 und ganz besonders bevorzugt im Bereich von 1 : 3 bis 1 : 6. Überraschenderweise wurde festgestellt, dass die Wärme- und Stromleitfähigkeit der Metall-Keramik-Substrate bei einem Verhältnis von Spitzentemperaturheizdauer (in min) zu Heizdauer (in min) im angegebenen Bereich weiter verbessert werden kann.

Beim Erhitzen erfolgt eine Temperaturzufuhr für eine Aufheizdauer. Die Aufheizdauer bezeichnet dabei vorzugsweise den Zeitraum, den der Stapel benötigt, um ausgehend von einer Temperatur von 100°C die Spitzentemperatur zu erreichen. Gemäß einer bevorzugten Ausführungsform (Bedingung b3) liegt die Aufheizdauer bei nicht mehr als 60 min, besonders bevorzugt bei nicht mehr als 45 min und ganz besonders bevorzugt bei nicht mehr als 30 min.

Die Aufheizdauer liegt vorzugsweise im Bereich von 1 - 60 min, mehr bevorzugt im Bereich von 5 - 45 min und besonders bevorzugt im Bereich von 10 - 30 min.

Überraschenderweise hat sich herausgestellt, dass ein Metall-Keramik-Substrat mit einer verbesserten Wärme- und Stromleitfähigkeit erhalten werden kann, wenn der Stapel erhitzt wird und dabei wenigstens eine der Bedingungen b1, b2 und b3 erfüllt ist, demnach eine Hochtemperaturheizdauer von 60 min nicht überschritten wird, eine Spitzentemperaturheizdauer von 30 min nicht überschritten wird und/oder eine Aufheizdauer von 60 min nicht überschritten wird.

Ohne an eine Theorie gebunden sein zu wollen, könnte dies darauf zurückzuführen sein, dass der Stapel bei einer geringen Hochtemperaturheizdauer, einer geringen Spitzentemperaturheizdauer und/oder einer geringen Aufheizdauer einen nur begrenzten Energieeintrag erfährt, der zwar ausreichend ist, um eine stoffschlüssige Verbindung zwischen dem Keramikkörper und der Metallfolie über das Lötmaterial zu erzeugen, der andererseits aber begrenzt ist, so dass eine übermäßige Diffusion von Metallen mit einem Schmelzpunkt von wenigstens 700°C und Metallen mit einem Schmelzpunkt von weniger als 700°C in die Metallfolie vermieden wird. Diese verminderte Diffusion könnte wiederum ursächlich für die verbesserte Strom- und Wärmeleitfähigkeit im fertigen Metall-Keramik-Substrat sein.

Der Stapel wird vorzugsweise erhitzt, indem ausgehend von einer Heizzone der für das Erhitzen erforderliche Energieeintrag in Richtung des Stapels erfolgt. Die Ausbildung der stoffschlüssigen Verbindung erfolgt vorzugsweise, indem das Aktivmetall eine Verbindung mit dem Keramikkörper eingeht und das Metall mit einem Schmelzpunkt von wenigstens 700°C, das Metall mit einem Schmelzpunkt von weniger als 700°C und das Metall der Metallfolie sich zu einer Legierung verbinden. Beim anschließenden Erstarren bildet sich dann eine stoffschlüssige Verbindung zwischen dem Keramikkörper und der Metallfolie über das Lötmaterial aus.

Die Anordnung von Stapel und Heizzone ist nicht weiter eingeschränkt.

Stapel und Heizzone können jeweils statisch angeordnet sein.

Andererseits kann es bevorzugt sein, dass der Stapel zum Erhitzen eine Heizzone passiert.

Gemäß dieser bevorzugten Ausführungsform herrschen in der Heizzone Bedingungen, die die Ausbildung einer stoffschlüssigen Verbindung zwischen der Keramik und der Metallfolie über das Lötmaterial ermöglichen. Die in der Heizzone vorliegende Temperatur und Atmosphäre sind vorzugsweise einstellbar. Die Heizzone weist vorzugsweise einen Einlass und einen Auslass auf. Beim Passieren der Heizzone tritt der Stapel vorzugsweise durch den Einlass in die Heizzone ein und durch den Auslass aus der Heizzone aus. Vorzugsweise ist der Einlass vom Auslass verschieden.

Gemäß einer weiteren bevorzugten Ausführungsform sind der Stapel und die Heizzone so angeordnet, dass die Position des Stapels relativ zur Position der Heizzone veränderbar ist, um dem Stapel ein Passieren der Heizzone zu ermöglichen. Vorzugsweise nimmt der Abstand zwischen dem Stapel und der Heizzone vor der Passage der Heizzone ab, erreicht bei Passage der Heizzone ein Minimum und nimmt nach Passage der Heizzone zu. Gemäß einer bevorzugten Ausführungsform erfolgt eine Relativbewegung von Stapel und Heizzone, wobei Stapel und Heizzone zunächst eine Relativbewegung zueinander und nach dem Passieren eine Relativbewegung voneinander weg ausführen. Hierzu kann der Stapel stationär und die Heizzone mobil angeordnet, der Stapel mobil und die Heizzone stationär angeordnet oder Stapel und Heizzone mobil angeordnet sein.

Beim Passieren der Heizzone erfährt der Stapel daher vorzugsweise eine Temperaturzufuhr. Demnach befindet sich beim Passieren der Stapel in einem Abstand zur Heizzone, der einen für die Ausbildung einer stoffschlüssigen Verbindung zwischen dem Keramikkörper und der Metallfolie erforderlichen Temperatureintrag gewährleistet.

Überraschenderweise hat sich herausgestellt, dass ein Metall-Keramik-Substrat mit einer weiter verbesserten Wärme- und Stromleitfähigkeit erhalten werden kann, wenn der Stapel beim Erhitzen eine Heizzone passiert. Ohne an eine Theorie gebunden sein zu wollen, könnte dies darauf zurückzuführen sein, dass durch eine Passage der Heizzone eine gezielte Steuerung des Energieeintrags erreicht werden kann. Passiert der Stapel die Heizzone, kann die Temperatur in der Heizzone und die Geschwindigkeit, mit der der Stapel die Heizzone passiert, auf den Aufbau und die Dimension des Stapels ideal abgestimmt werden, so dass nur der für die Ausbildung einer stoffschlüssigen Verbindung zwischen dem Keramikkörper und der Metallfolie erforderliche Energieeintrag erfolgt. Dies verhindert einen übermäßig starken Energieeintrag, der regelmäßig zu einer erhöhten Diffusion von Metallen mit einem Schmelzpunkt von wenigstens 700°C und Metallen mit einem Schmelzpunkt von weniger als 700°C in die Metallfolie führt, die schließlich ursächlich für eine Abnahme der Strom- und Wärmeleitfähigkeit im fertigen Metall-Keramik-Substrat sein kann. Ferner wird bei einer Passage der Heizzone eine gleichmäßige Verteilung der Temperatur und der in der Heizzone enthaltenen Gase (zum Beispiel Inertgase) sichergestellt. Dadurch kommt es dann, wenn mehrere Metall-Keramik-Substrate mit dem erfindungsgemäßen Verfahren hergestellt werden, zu einer geringeren Variation der Qualität der hergestellten Metall-Keramik-Substrate im Vergleich zu herkömmlichen Verfahren (zum Beispiel unter Verwendung eines Kammerofens). Insofern hat sich eine Relativbewegung des Stapels in Richtung einer Heizzone, wobei der Stapel die Heizzone passiert, gegenüber dem stationären Erhitzen (zum Beispiel in einem Kammerofen) als vorteilhaft herausgestellt.

Gemäß einer besonders bevorzugten Ausführungsform erfolgt das Erhitzen des Stapels in einem Ofen, vorzugsweise in einem Durchlaufofen.

Der Ofen weist vorzugsweise eine Heizzone und ein Trägersystem auf. Auf dem Trägersystem ist vorzugsweise der Stapel angeordnet. Vorzugsweise sind die Heizzone und das Trägersystem so ausgestaltet, dass die Position des Stapels relativ zur Position der Heizzone veränderbar ist, um ein Erhitzen des Stapels unter Passieren der Heizzone zu gestatten. Vorzugsweise sind die Heizzone und das Trägersystem daher so ausgestaltet, dass der Abstand zwischen dem Stapel und der Heizzone verkleinerbar ist, bis der Abstand bei Passage der Heizzone ein Minimum einnimmt, und der Abstand nach der Passage der Heizzone vergrößerbar ist. Gemäß einer bevorzugten Ausführungsform sind daher die Heizzone und das Trägersystem für eine Relativbewegung ausgestaltet, so dass Stapel und Heizzone zunächst eine Relativbewegung zueinander und nach dem Passieren eine Relativbewegung voneinander weg ausführen.

Bei dem Ofen kann es sich vorzugsweise um einen Durchlaufofen handeln. Dementsprechend erfolgt gemäß einer bevorzugten Ausführungsform das Erhitzen des Stapels in einem Durchlaufofen, wobei der Stapel beim Erhitzen die Heizzone des Durchlaufofens passiert. Ein Durchlaufofen weist vorzugsweise wenigstens eine Heizzone und als Trägersystem beispielsweise eine umlaufende Transportkette, ein Transportrollensystem oder ein Transportschiebesystem auf, auf dem ein Werkstück durch die Heizzone transportiert werden kann. In Transportrichtung vor der Heizzone und nach der Heizzone können sich im Durchlaufofen weitere Zonen befinden. So kann es vorteilhaft sein, dass sich im Durchlaufofen hinter der Heizzone eine Abkühlzone befindet. Außerdem kann es vorteilhaft sein, dass sich in der Heizzone und den gegebenenfalls vorhandenen weiteren Zonen Gaseinlässe und Gasauslässe befinden, durch die eine Versorgung der Zonen mit Gas (zum Beispiel einem Inertgas wie Stickstoff) erfolgen kann. Derartige Durchlauföfen sind aus dem Stand der Technik hinlänglich bekannt (siehe zum Beispiel DE 4008979 C1 und EP 0085914 A2).

Gemäß einer bevorzugten Ausführungsform des erfindungsgemäßen Verfahrens wird der Stapel zunächst auf einen Träger aufgebracht. Der Träger kann zum Beispiel aus Siliziumkarbid beschaffen sein. Der Träger aus Siliziumkarbid kann mit einer weiteren Auflage, zum Beispiel einer Graphitfolie, versehen sein.

Der - vorzugsweise auf einem Träger angeordnete Stapel - wird im Anschluss vorzugsweise auf ein Trägersystem, zum Beispiel ein Transportband, gestellt. Bei dem Transportband kann es sich zum Beispiel um eine Transportkette, ein Transportrollensystem oder ein Transportschiebesystem eines Durchlaufofens handeln.

Gemäß einer bevorzugten Ausführungsform passiert der Stapel die Heizzone auf dem Trägersystem. Das Trägersystem wird vorzugsweise angetrieben, zum Beispiel über Walzen.

In der Heizzone liegt vorzugsweise eine nichtoxidierende Atmosphäre vor. Die nichtoxidierende Atmosphäre ist vorzugsweise eine Inertgasatmosphäre. Vorzugsweise liegt in der Heizzone eine Stickstoffatmosphäre, eine Heliumatmosphäre oder eine Argonatmosphäre vor. Gemäß einer besonders bevorzugten Ausführungsform liegt in der Heizzone eine Stickstoffatmosphäre vor. Vorzugsweise liegt der Anteil an einem reaktiven Gas, insbesondere Sauerstoff, in der nichtoxidierenden Atmosphäre bei weniger als 1000 ppm, mehr bevorzugt bei weniger als 500 ppm und besonders bevorzugt bei weniger als 40 ppm.

Beim Erhitzen des Stapels erfolgt vorzugsweise die Ausbildung einer stoffschlüssigen Verbindung zwischen dem Keramikkörper und der Metallfolie über das Lötmaterial unter Erhalt eines Metall-Keramik-Substrats. Das Metall-Keramik-Substrat kann bei Bedarf weiteren Behandlungsschritten unterzogen werden. Beispielsweise kann das Metall-Keramik-Substrat, vorzugsweise die freiliegende Oberfläche der Metallfolie des Metall-Keramik-Substrats, poliert werden. Vorzugsweise wird die Oberfläche der Metallfolie des Metall-Keramik-Substrats physisch oder chemisch poliert. Ferner kann das Metall-Keramik-Substrat strukturiert werden. Zum Beispiel kann das Metall-Keramik-Substrat mit Leiterbahnen versehen werden. Die Leiterbahnen werden vorzugsweise durch Ätzen erzeugt.

Das erfindungsgemäß hergestellte Metall-Keramik-Substrat kann insbesondere für Anwendungen in der Elektronik, vor allem für den Bereich der Leistungselektronik, eingesetzt werden.

### Ausführungsbeispiele:

In den Beispielen wurden Metall-Keramik-Substrate unter verschiedenen Bedingungen hergestellt. Dabei wurde jeweils ein Stapel enthaltend einen Keramikkörper, eine Metallfolie und ein Lötmaterial, das mit dem Keramikkörper und der Metallfolie in Kontakt steht, bereitgestellt und anschließend erhitzt. Bei dem Lötmaterial handelte es sich um eine Standardpaste, die als Metalle Kupfer, Zinn und Titan enthielt. Anschließend wurde die Strom- und Wärmeleitfähigkeit qualitativ bewertet. Vergleichbare Ergebnisse lassen sich auch mit anderen Materialkombinationen erreichen.

### Beispiel 1:

Für die Herstellung von Metall-Keramik-Substraten wurden zunächst 31,67 Gewichtsprozent SnCu0.7-Pulver, 7,24 Gewichtsprozent Titanhydrid und 9,50 Gewichtsprozent eines organischen Vehikels enthaltend Texanol bei 35 Hz für 20 Minuten in einem Standmischgerät gemischt. Danach wurden 51,59 Gewichtsprozent Kupferpulver in Inkrementen zugegeben. Die so erzeugte Mischung wurde bei hoher Geschwindigkeit solange gerührt, bis eine homogene Paste erhalten wurde.

Mit der so hergestellten Paste wurden Keramikkörper an ihren gegenüberliegenden Oberflächen beidseitig mit Kupferfolien verbunden. Hierzu wurden jeweils Keramikkörper mit den Abmessungen 177,8 x 139,7 x 0,32 mm (erhalten von Toshiba Materials) verwendet, die eine identische Vorder- und Rückseitenbeschaffung aufwiesen. Die Paste wurde mittels eines 165 Mesh-Siebs auf einen Bereich der Abmessung 137 x 175 mm² auf die Rückseite eines solchen Keramikkörpers siebgedruckt und für 15 Minuten bei 125°C vorgetrocknet. Die Pastendicke nach der Vortrocknung betrug 35 +/- 5 µm. Danach wurde die so erzeugte Anordnung herumgedreht, die Paste gleichermaßen auf die Vorderseite des Keramikkörpers gedruckt und vorgetrocknet. Anschließend wurde die beidseitig mit Paste versehene Keramik beidseitig mit Kupferfolie aus sauerstofffreiem, hochleitfähigem Kupfer mit einer Reinheit von 99,99% und einer Abmessung von 174 x 137 x 0.3 mm versehen, um einen Stapel mit folgendem Aufbau zu erhalten: Kupferfolie - vorgetrocknete Paste - Keramik - vorgetrocknete Paste - Kupferfolie.

Der Stapel wurde sodann in einem Durchlaufofen erhitzt. Hierzu wurde auf die Transportkette eines Durchlaufofens zunächst eine Siliziumcarbidplatte gelegt, auf die eine Graphitfolie aufgebracht wurde. Auf der Graphitfolie wurde der Stapel platziert, der danach mit einer weiteren Graphitfolie abgedeckt und mit einer weiteren Siliziumcarbidplatte (Gewicht = 600 g) beschwert wurde. Der Aufbau wurde anschließend auf der Transportkette durch die Heizzone eines Durchlaufofens transportiert. Die Spitzentemperatur (gemessen mit einem Thermoelement vom Typ K der Firma Temperatur Messelemente Hettstedt GmbH am Stapel) betrug 935°C und die Aufheizdauer lag bei 17 min. Die Heizdauer betrug 29,5 min, die Hochtemperaturheizdauer betrug 13 min und die Spitzentemperaturheizdauer betrug 6,5 min. Das so erhaltene Metall-Keramik-Substrat wurde anschließend auf Raumtemperatur abgekühlt, um ein Metall-Keramik-Substrat zu erhalten, das eine Keramikschicht enthielt, die beidseitig mit einer Kupferschicht über eine Verbindungsschicht verbunden war.

### Beispiel 2:

Beispiel 2 wurde analog zu Beispiel 1 mit geänderten Heizparametern durchgeführt. Die Spitzentemperatur (gemessen mit einem Thermoelement vom Typ K der Firma Temperatur Messelemente Hettstedt GmbH am Stapel) betrug 910°C und die Aufheizdauer lag bei 21,5 min. Die Heizdauer betrug bei 41 min, die Hochtemperaturheizdauer betrug 17 min und die Spitzentemperaturheizdauer betrug 7 min.

### Vergleichsbeispiel:

Das Vergleichsbeispiel wurde analog zu Beispiel 1 durchgeführt, wobei der Stapel jedoch statt in einem Durchlaufofen in einem Kammerofen erhitzt wurde. Die Spitzentemperatur (gemessen mit einem Thermoelement vom Typ K der Firma Temperatur Messelemente Hettstedt GmbH am Stapel) betrug 910°C und die Aufheizdauer lag bei 230 min. Die Heizdauer betrug 380 min, die Hochtemperaturheizdauer betrug 120 min und die Spitzentemperaturheizdauer betrug 35 min. Das so erhaltene Metall-Keramik-Substrat wurde anschließend auf Raumtemperatur abgekühlt, um ein Metall-Keramik-Substrat zu erhalten, das eine Keramikschicht enthielt, die beidseitig mit einer Kupferschicht über eine Verbindungsschicht verbunden war.

Die Wärme- und Stromleitfähigkeit der in den Beispielen erhaltenen Metall-Keramik-Substrate wurde anschließend wie folgt bewertet:

| **Beispiel** | **Leitfähigkeit** |
|---|---|
| Beispiel 1 | hoch |
| Beispiel 2 | hoch |
| Vergleichsbeispiel | gering |

Es zeigte sich, dass die Leitfähigkeit von Metall-Keramik-Substraten bei Anwendung des erfindungsgemäßen Verfahrens deutlich verbessert werden kann. Ohne an eine Theorie gebunden sein zu wollen, könnte dies darauf zurückzuführen sein, dass das Metall mit einem Schmelzpunkt von weniger als 700°C (in den Beispielen Zinn) beim erfindungsgemäßen Verfahren weniger tief in die Metallfolie eindringt als dies bei herkömmlichen Verfahren der Fall ist. So konnte gezeigt werden, dass das Metall mit einem Schmelzpunkt von weniger als 700°C (in den Beispielen Zinn) beim erfindungsgemäßen Verfahren weniger tief in die Metallfolie eindringt als dies bei herkömmlichen Verfahren der Fall ist. Eine Tiefenprofilanalyse ergab für die in den Beispielen 1 und 2 erhaltenen Metall-Keramik-Substrate eine um mehr als 30% verminderte Diffusion von Zinn in die Kupferfolie verglichen mit dem Metall-Keramik-Substrat des Vergleichsbeispiels. Folglich ist in den Beispielen 1 und 2 die Leitfähigkeit des fertigen Metall-Keramik-Substrats weniger stark beeinträchtigt.

## Patentansprüche

1. Verfahren zur Herstellung eines Metall-Keramik-Substrats umfassend die Schritte:
a) Bereitstellen eines Stapels enthaltend
a1) einen Keramikkörper,
a2) eine Metallfolie und
a3) ein Lötmaterial, das mit dem Keramikkörper und der Metallfolie in Kontakt steht, wobei das Lötmaterial umfasst:
(i) ein Metall mit einem Schmelzpunkt von wenigstens 700°C,
(ii) ein Metall mit einem Schmelzpunkt von weniger als 700°C und
(iii) ein Aktivmetall, und
b) Erhitzen des Stapels, wobei wenigstens eine der folgenden Bedingungen erfüllt ist:
b1) die Hochtemperaturheizdauer beträgt nicht mehr als 60 min, wobei sich die Hochtemperaturheizdauer auf die Zeitdauer bezieht, bei der der Stapel beim Erhitzen einer Temperatur ausgesetzt ist, die wenigstens der Spitzentemperatur - 250°C entspricht;
b2) die Spitzentemperaturheizdauer beträgt nicht mehr als 30 min, wobei sich die Spitzentemperaturheizdauer auf die Zeitdauer bezieht, bei der der Stapel beim Erhitzen einer Temperatur ausgesetzt ist, die wenigstens der Spitzentemperatur - 50°C entspricht;
b3) die Aufheizdauer liegt bei nicht mehr als 60 min, wobei die Aufheizdauer den Zeitraum bezeichnet, den der Stapel benötigt, um ausgehend von einer Temperatur von 100°C die Spitzentemperatur zu erreichen.

2. Verfahren nach Anspruch 1, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

3. Verfahren nach Anspruch 1 oder 2, **dadurch gekennzeichnet, dass** das Metall der Metallfolie Kupfer ist.

4. Verfahren nach einem der vorangegangenen Ansprüche, **dadurch gekennzeichnet, dass** das Lötmaterial eine Paste ist, die (a) wenigstens eine Metallkomponente, die ein Metall mit einem Schmelzpunkt von wenigstens 700°C, ein Metall mit einem Schmelzpunkt von weniger als 700°C und ein Aktivmetall aufweist, und (b) ein organisches Medium enthält.

5. Verfahren nach einem der vorangegangenen Ansprüche, **dadurch gekennzeichnet, dass** das Metall mit einem Schmelzpunkt von wenigstens 700°C Kupfer ist.

6. Verfahren nach einem der vorangegangenen Ansprüche, **dadurch gekennzeichnet, dass** das Metall mit einem Schmelzpunkt von weniger als 700°C aus der Gruppe ausgewählt ist, die aus Zinn, Bismut, Indium, Gallium, Zink, Antimon und Magnesium besteht.

7. Verfahren nach einem der vorangegangenen Ansprüche, **dadurch gekennzeichnet, dass** das Aktivmetall aus der Gruppe ausgewählt ist, die aus Hafnium, Titan, Zirkonium, Niob, Tantal, Vanadium und Cer besteht.

8. Verfahren nach einem der vorangegangenen Ansprüche, **dadurch gekennzeichnet, dass** der Anteil von Silber weniger als 3,0 Gewichtsprozent, bezogen auf das Gesamtmetallgewicht des Lötmaterials beträgt.

9. Verfahren nach einem der vorangegangenen Ansprüche, **dadurch gekennzeichnet, dass** der Stapel zum Erhitzen eine Heizzone passiert.

10. Verfahren nach Anspruch 9, **dadurch gekennzeichnet, dass** in der Heizzone eine nichtoxidierende Atmosphäre vorliegt.

11. Verfahren nach Anspruch 9 oder 10, **dadurch gekennzeichnet, dass** in der Heizzone eine Stickstoffatmosphäre vorliegt.

12. Verfahren nach einem der vorangegangenen Ansprüche, **dadurch gekennzeichnet, dass** das Erhitzen in einem Durchlaufofen erfolgt.

13. Verfahren nach einem der vorangegangenen Ansprüche, **dadurch gekennzeichnet, dass** die Spitzentemperatur im Bereich von 700 - 1100°C liegt.

14. Verfahren nach einem der vorangegangenen Ansprüche, **dadurch gekennzeichnet, dass** die Heizdauer nicht mehr als 5 h beträgt, wobei sich die Heizdauer auf die Zeitdauer bezieht, bei der der Stapel beim Erhitzen einer Temperatur von wenigstens 200°C ausgesetzt ist.
